# FASCICULE DE BREVET EUROPEEN

(11) **EP 1 702 192 B1**
(45) Date de publication et mention de la délivrance du brevet: **18.04.2007**
(21) Numéro de dépôt: 04816462.8
(22) Date de dépôt: 22.12.2004
(51) Int. Cl.: F28F 9/26, H01L 23/473

(54) **ECHANGEUR THERMIQUE**
WÄRMETAUSCHER
HEAT EXCHANGER

(30) Priorité: 23.12.2003 FR 0315257
(43) Date de publication de la demande: 20.09.2006
(73) Titulaire: Cooltech Applications, 68280 Andolsheim (FR)
(72) Inventeur: MULLER, Christian, 67000 Strassbourg (FR); DUPIN, Jean-Louis, 68320 Muntzenheim (FR); HEITZLER, Jean-Claude, 68180 Horbourg-Wihr (FR)
(74) Mandataire: Nithardt, Roland
(86) Numéro de dépôt international: PCT/FR2004/003332
(87) Numéro de publication internationale: WO 2005/064245

(56) Documents cités:
- US-A- 3 481 393
- US-A- 4 644 385
- US-A- 5 509 468

## Description

### Domaine technique :

La présente invention concerne un échangeur thermique comportant au moins un groupe d'au moins deux éléments thermiques émetteurs de calories et/ou de frigories et pourvus chacun d'au moins un orifice d'entrée et d'au moins un orifice de sortie reliés par au moins un conduit traversant l'élément thermique apte à recevoir un fluide thermique agencé pour récupérer les calories et/ou les frigories, l'échangeur thermique comportant des moyens de raccordement agencés pour raccorder les conduits entre eux et à au moins un circuit extérieur à l'échangeur thermique agencé pour utiliser les calories et/ou frigories récupérées par ledit fluide thermique.

### Technique antérieure :

De manière connue, les échangeurs thermiques traditionnels comportent des éléments thermiques reliés entre eux et à un ou plusieurs circuits extérieurs de fluide thermique au moyen de tuyaux, de raccords et de joints d'étanchéité. Les raccords sont de préférence démontables pour faciliter leur montage et les opérations de maintenance. Cette technique de raccordement est longue à mettre en oeuvre et nécessite un nombre important de pièces qui rend difficile la maîtrise de l'étanchéité de ce type d'échangeur thermique.

Un exemple est illustré dans la publication WO-A-03/050456 qui décrit un échangeur thermique magnéto calorique comportant douze éléments thermiques à base de gadolinium soumis alternativement à un champ magnétique généré par un aimant permanent en rotation. Chaque élément thermique est pourvu d'au minimum quatre orifices dont deux orifices d'entrée et deux orifices de sortie, reliés deux à deux par des conduits et raccordés aux circuits extérieurs "chaud" et "froid" par des joints tournants. Chaque joint tournant comporte sept raccords raccordant sélectivement les conduits, selon la position de l'aimant permanent, aux circuits extérieurs "chaud" et "froid". Cet échangeur thermique comporte donc quatre joints tournants par élément thermique soit quarante huit raccords auxquels s'ajoutent sept raccords pour chacun des quatre joints tournants soit vingt huit raccords de plus, d'où un total de soixante seize raccords. Ce nombre important de raccords augmente d'autant le nombre d'organes mécaniques ainsi que les risques de fuites de fluide thermique. De plus, il limite considérablement les perspectives d'évolution technique de cet échangeur technique et le rend économiquement non rentable. Enfin, cet échangeur thermique, dont le fonctionnement est peu fiable, est techniquement difficile et coûteux à réaliser. Cette solution n'est donc pas satisfaisante.

Une autre technique de raccordement est illustrée dans les publications US-A-4,644,385 et US-A-5,509,468 et prévoit de remplacer les tuyaux par des plaques rigides intégrant des canaux de circulation du fluide de refroidissement pour radiateurs de circuits électroniques. Dans ce type d'application, le radiateur comporte pour chaque circuit électronique une plaque individuelle agencée pour absorber les calories dissipées, connectée à une plaque collectrice couplée à un échangeur de chaleur. Toutefois, la liaison entre les différentes plaques et l'échangeur de chaleur nécessite des raccords spécifiques rigides ou souples intégrant ou non une vanne. Cette solution ne permet donc pas de s'affranchir des pièces de raccordement et des inconvénients qui y sont associés. De plus, dans ce type d'application, le circuit de refroidissement est figé et non évolutif, l'objectif étant simplement la dissipation des calories.

### Exposé de l'invention:

La présente invention vise à pallier ces inconvénients en proposant un échangeur thermique permettant, de manière efficace, simple, fiable et pour un coût modéré, de raccorder les éléments thermiques entre eux et à un ou plusieurs circuits extérieurs, tout en limitant les risques de fuite et le nombre de pièces mécaniques et en facilitant les opérations de maintenance. L'invention propose un échangeur thermique autorisant l'utilisation d'un nombre important d'éléments thermiques et/ou plusieurs groupes d'éléments thermiques pouvant être raccordés selon une configuration série, parallèle ou mixte, le nombre d'éléments thermiques et la configuration de raccordement pouvant aisément être modifiés.

Dans ce but, l'invention concerne un échangeur thermique du genre indiqué en préambule, caractérisé en ce que les moyens de raccordement comportent au moins une plaque d'interface plaquée contre les éléments thermiques, comprenant au moins une canalisation pourvue d'orifices de liaison disposés en regard des orifices d'entrée et de sortie des éléments thermiques et agencée pour définir au moins un circuit d'interface autorisant la circulation du fluide thermique entre lesdits éléments thermiques et la plaque d'interface selon un raccordement série, parallèle ou mixte, la plaque d'interface étant également pourvue d'au moins un orifice d'arrivée et d'au moins un orifice d'évacuation agencés pour raccorder le circuit d'interface au circuit extérieur.

Dans une forme préférée de l'invention, les éléments thermiques émettent alternativement des calories et des frigories et la plaque d'interface comporte au moins deux canalisations, pourvues chacune d'au moins un orifice d'arrivée, un orifice d'évacuation et des orifices de liaison, et agencées pour définir deux circuits d'interface distincts raccordés à deux circuits extérieurs.

De manière avantageuse, l'échangeur thermique comporte au moins deux groupes d'éléments thermiques pourvus chacun d'au moins une plaque d'interface et de moyens de raccordement complémentaires agencés pour raccorder les plaques d'interface entre elles et les circuits d'interface desdits groupes correspondants selon un raccordement série, parallèle ou mixte.

Selon une variante de réalisation, les moyens de raccordement comportent au moins deux plaques d'interface superposées dos à dos, comportant chacune au moins une canalisation, un orifice d'arrivée, un orifice d'évacuation et des orifices de liaison raccordés à un ensemble d'éléments thermiques. Ces plaques d'interface peuvent comporter des orifices traversants disposés en regard les uns des autres pour définir un circuit d'interface commun.

La canalisation peut être au moins en partie formée par un réseau de trous traversants prévus dans l'épaisseur de la plaque d'interface et obturés sélectivement par des bouchons en fonction du circuit d'interface à réaliser.

La canalisation peut également être au moins en partie formée par une ou plusieurs rainures ménagées sur au moins une face de la plaque d'interface et réalisées par usinage, gravure ou moulage. Dans ce cas, les moyens de raccordement comportent avantageusement au moins une plaque d'obturation superposée à la plaque d'interface du côté de la rainure pour former la canalisation.

La plaque d'obturation peut être disposée entre deux plaques d'interface et agencée pour former avec chacune d'elle une canalisation. Cette plaque d'obturation peut comporter des orifices traversants débouchant dans lesdites canalisations et agencés pour les raccorder selon un raccordement série, parallèle ou mixte.

De préférence, les moyens de raccordement sont réalisés dans une matière thermiquement isolante et comportent des moyens d'étanchéité disposés au moins entre les éléments thermiques et la plaque d'interface, ces moyens d'étanchéité pouvant être un revêtement ou une feuille "Téflon", un joint liquide, ou similaire.

Selon un mode de réalisation préféré, la plaque d'obturation comporte un commutateur mobile entre au moins deux positions de manière à modifier le mode de raccordement desdits circuits d'interface. Ce commutateur peut être choisi dans le groupe comprenant au moins un coulisseau, un noyau, un tiroir et peut être commandé par des moyens d'asservissement.

### Description sommaire des dessins :

La présente invention et ses avantages apparaîtront mieux dans la description suivante de plusieurs modes de réalisation en référence aux dessins annexés donnés à titre d'exemples non limitatifs, dans lesquels :
- les figures 1A-C sont respectivement des vues de dessus, de coté et de dessus en transparence d'un premier mode de réalisation d'un échangeur thermique selon l'invention,
- la figure 1D est une vue similaire à la figure 1C sur laquelle les circuits thermiques chaud et froid sont schématisés,
- les figures 1E et 1F sont des vues en coupe selon les lignes AA et BB de la plaque d'interface seule de l'échangeur thermique de la figure 1D,
- les figures 1G et 1H sont des vues en coupe de l'échangeur thermique des figures précédentes sur lesquelles les circuits thermiques chaud et froid sont schématisés,
- les figures 1I et 1J sont des vues éclatées en perspective de dessus et de dessous de l'échangeur thermique des figures précédentes,
- les figures 2A, 2B et 2D sont respectivement des vues éclatées en perspective de dessous et de dessus et une vue de coté d'un deuxième mode de réalisation de l'échangeur thermique selon l'invention,
- la figure 2C est une vue similaire à la figure 1D de l'échangeur thermique de la figure 2A,
- les figures 3A et 3B sont respectivement des vues de dessus et de coté d'un troisième mode de réalisation de l'échangeur thermique selon l'invention,
- la figure 3C illustre l'assemblage par superposition des plaques d'interface et de la plaque d'obturation pour former les moyens de raccordement de l'échangeur thermique des figures 3A, B,
- les figures 3D et 3E sont des vues éclatées en perspective de dessus et de dessous de l'échangeur thermique des figures 3A-C,
- les figures 4A-D sont des vues de coté en coupe de plusieurs modes de réalisation des moyens de raccordement de l'échangeur thermique selon l'invention,
- les figures 5A, 6A, 7A sont des vues de dessus de trois autres modes de réalisation d'échangeurs thermiques selon l'invention,
- les figures 5B, 6B, 7B sont des vues similaires aux figures 5A, 6A, 7A sur lesquelles les circuits thermiques chaud et froid sont schématisés,
- les figures 8A et 8B sont des vues de dessus d'un autre mode de réalisation d'un échangeur thermique selon l'invention sur chacune desquelles une partie des circuits thermiques chaud et froid sont schématisés,
- les figures 9A et 9B sont respectivement des vues en perspective éclatée partielle et non éclatée complète d'un autre mode de réalisation de l'échangeur thermique selon l'invention, et
- les figures 10, 11A-C sont des vues en perspective d'autres modes de réalisation de l'échangeur thermique selon l'invention.

### Illustrations de l'invention :

En référence aux figures et de manière connue, l'échangeur thermique 1a-o comporte un ou plusieurs groupes 200a-o d'éléments thermiques 2a-o émetteurs de calories et/ou de frigories portés par un support sur lequel ils sont fixés par des moyens de fixation (non représentés) permanents ou démontables, tels que par exemple le collage, la soudure, le vissage, le sertissage, le surmoulage.

Dans les exemples illustrés, les éléments thermiques 2a-o sont du type magnéto calorique. Il est bien entendu qu'ils peuvent être de tout autre type et fonctionner selon tout autre principe adapté. Chaque élément thermique 2a-o contient un matériau magnéto calorique tel que par exemple du gadolinium (Gd) ou tout autre matériau équivalent. Ainsi, lorsque l'élément thermique 2a-o est soumis à la présence d'un champ magnétique, il s'échauffe et lorsque le champ magnétique disparaît, il se refroidit à une température inférieure à sa température initiale. Le principe de fonctionnement des échangeurs thermiques 1a-o, donnés à titre d'exemple, consiste donc à soumettre alternativement les éléments thermiques 2a-o à la présence et à l'absence d'un champ magnétique et à récupérer les calories et/ou les frigories successivement émises par chaque élément thermique 2a-o au moyen d'un fluide thermique en circulation. Pour ce faire, le champ magnétique est prévu mobile par rapport aux éléments thermiques et/ou variable et chaque élément thermique 2a-o est traversé par au moins un conduit 20 dont les orifices d'entrée 21 et de sortie 22 sont raccordés, par des moyens de raccordement 3a-o, à un ou plusieurs circuits extérieurs (non représentés) dans lesquels le fluide thermique est mis en circulation et les calories et/ou les frigories sont utilisées dans une installation pour réchauffer, refroidir, climatiser et/ou tempérer une atmosphère.

Le nombre d'éléments thermiques 2a-o prévus dans chaque groupe 200a-o peut être adapté selon les besoins et le type de fonctionnement souhaité.

Dans les exemples représentés, le conduit 20 traversant les éléments thermiques 2a-o a une forme en U. Il peut bien entendu avoir toute autre forme adaptée. Selon une variante de réalisation non représentée, le conduit 20 peut par exemple comporter une chambre interne pouvant recevoir le matériau magnéto calorique par exemple sous forme de pastilles.

Le champ magnétique est par exemple généré par des aimants permanents ou par des assemblages magnétiques (non représentés) chevauchant les éléments thermiques 2a-o et disposés en quinconce pour solliciter un élément thermique 2a-o sur deux. Le champ magnétique peut également être généré par des aimants permanents (non représentés) adjacents sollicitant alternativement et simultanément tous les éléments thermiques 2a-o. Les aimants permanents sont fixes ou couplés à des moyens de déplacement (non représentés) les rendant mobiles par rapport aux éléments thermiques 2a-o. Ces moyens de déplacement peuvent être alternatifs, pas à pas ou continus, et générer un déplacement des aimants permanents en rotation, par pivotement, en translation ou en toute combinaison de mouvements et de trajectoires telle que par exemple un mouvement hélicoïdal, une translation circulaire, une translation sinusoïdale ou une translation suivant toute autre trajectoire adaptée. Les moyens de déplacement comportent par exemple un moteur, un vérin, un mécanisme à ressort, un aérogénérateur, un électroaimant, un hydrogénérateur ou tout autre moyen équivalent. Les aimants permanents peuvent également être alignés cote à cote pour solliciter tous les éléments thermiques d'une même série.

Selon l'invention, les moyens de raccordement de l'échangeur thermique 2a-o comportent au moins une plaque d'interface 3a-o pourvue d'une ou de plusieurs canalisations 34. Ces canalisations 34 comportent des orifices de liaison 30 raccordés directement aux orifices d'entrée 21 et de sortie 22 pour mettre en communication les conduits 20 des différents éléments thermiques 2a-o et définir un ou plusieurs circuits d'interface 4a-o autorisant la circulation du fluide thermique entre les éléments thermiques 2a-o. Cette plaque d'interface 3a-o est également pourvue d'un ou de plusieurs orifices d'arrivée 31 et d'évacuation 32 destinés à raccorder le ou les circuits d'interface 4a-o à un ou plusieurs circuits extérieurs, par exemple un circuit extérieur "chaud" et un circuit extérieur "froid".

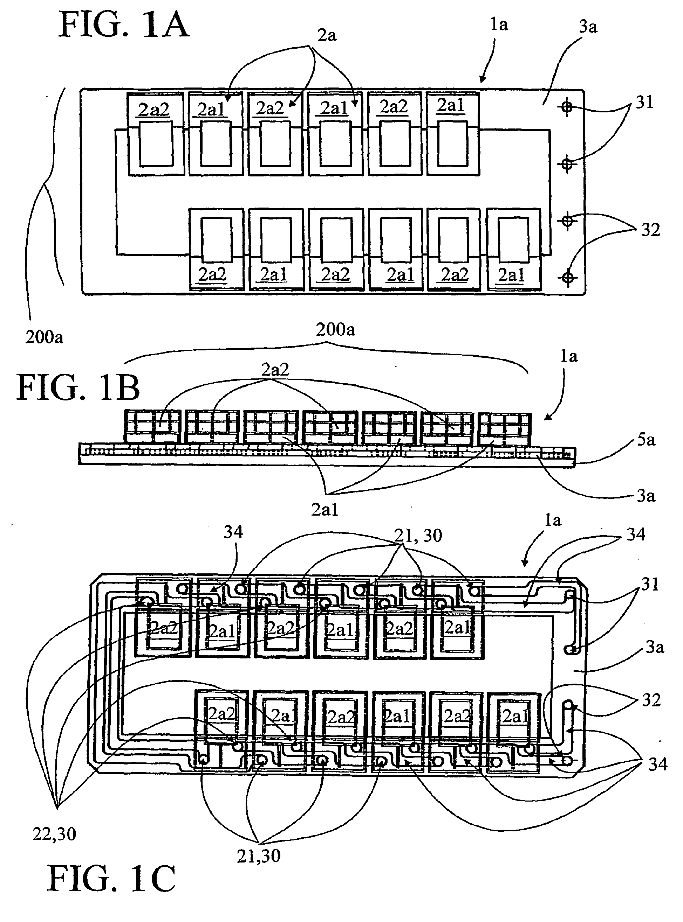

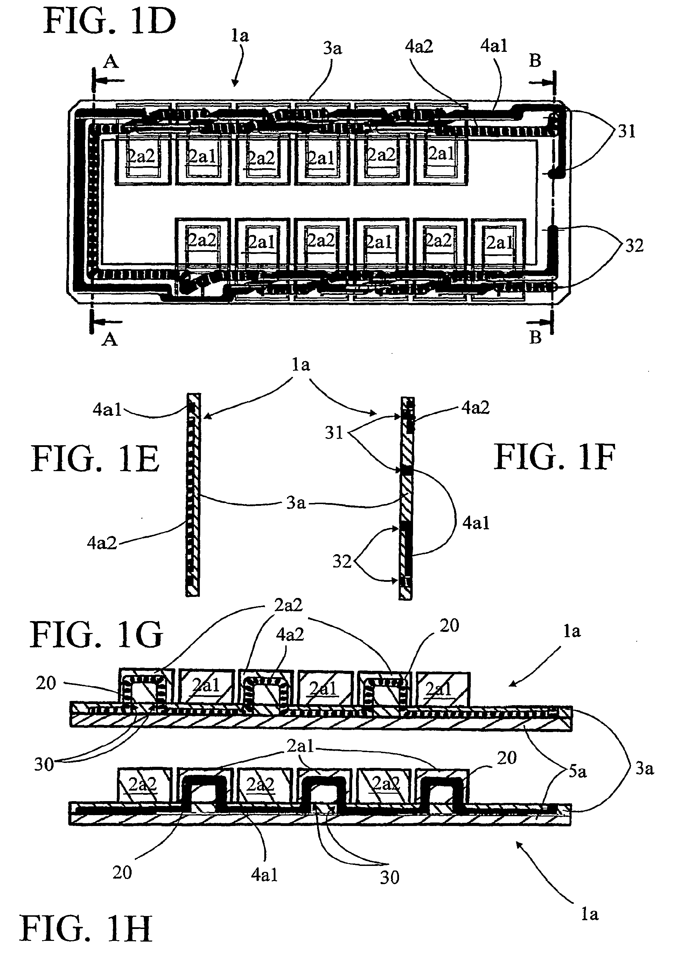

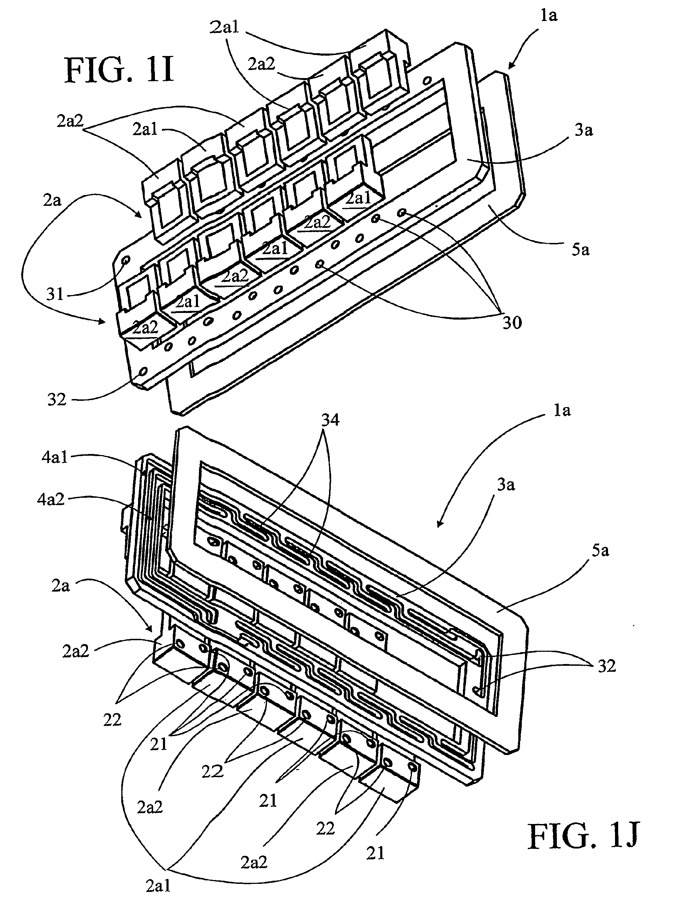

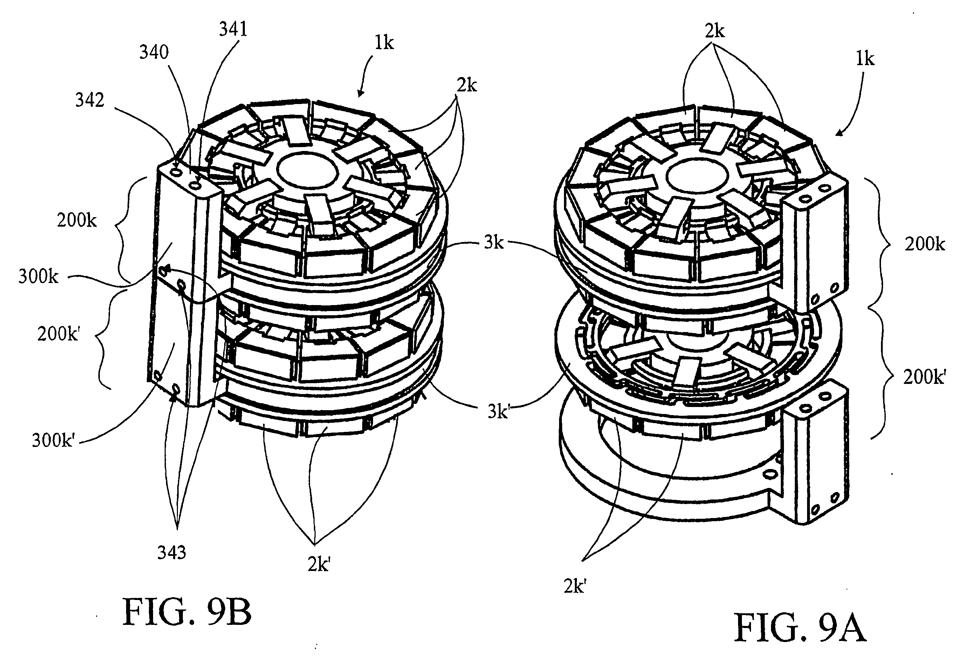

Selon les exemples représentés aux figures 1-8, les échangeurs thermiques 1a-j comportent chacun un seul groupe 200a-j d'éléments thermiques 1a-j alors qu'en référence aux figures 9-11, les échangeurs thermiques 1k-o comportent chacun plusieurs groupes 200k-o d'éléments thermiques 1k-o. Ces différents exemples ont pour but de montrer les multiples possibilités de combinaison envisageables avec la présente invention.

En référence aux figures 1A-J et selon un premier mode de réalisation, l'échangeur thermique 1a comporte un groupe 200a de deux rangées de six éléments thermiques 2a1, 2a2 alternés et assemblés à une plaque d'interface 3a formant un cadre rectiligne. Les éléments thermiques 2a1, 2a2 sont simultanément soumis à la présence et à l'absence de champ magnétique et sont reliés à la plaque d'interface 3a de manière à définir deux circuits d'interface 4a1, 4a2 distincts. Cet échangeur thermique 1a permet ainsi de récupérer simultanément les calories émises par les éléments thermiques 2a1 d'un premier ensemble au moyen du premier circuit d'interface 4a1 et les frigories émises par les éléments thermiques 2a2 d'un second ensemble au moyen du second circuit d'interface 4a2 et inversement.

La plaque d'interface 3a peut être réalisée en un matériau thermiquement isolant et mécaniquement rigide tel que par exemple un matériau composite, un matériau synthétique ou tout autre matériau équivalent. Elle peut également être réalisée en un matériau thermiquement conducteur tel qu'un alliage métallique, une porcelaine, et être isolée thermiquement au niveau de ses parois extérieures par exemple au moyen d'un revêtement adapté. Cette plaque d'interface 3a comporte quatre orifices dont deux orifices d'arrivée 31 et deux orifices d'évacuation 32 reliés par des moyens de raccordement traditionnels (non représentés) à deux circuits extérieurs (non représentés) dont un circuit extérieur "chaud" et un circuit extérieur "froid".

On peut intercaler des moyens de commutation (non représentés) permettant de basculer d'un circuit extérieur à l'autre et inversement. Les moyens de commutation permettent de raccorder alternativement chaque circuit d'interface 4a1, 4a2 au circuit extérieur "chaud" puis au circuit extérieur "froid". Ils comportent par exemple des vannes, des tiroirs à commande électrique, pneumatique, hydraulique ou tout autre moyen adapté. Les circuits extérieurs comportent des moyens de circulation libre ou forcée du fluide thermique (non représentés) tels que par exemple une pompe ou tout autre moyen équivalent. Chaque circuit extérieur "chaud" et "froid" est en outre pourvu d'un ou de plusieurs échangeurs thermiques respectivement de calories et de frigories ou de tout autre moyen équivalent permettant la diffusion et l'utilisation de ces calories et de ces frigories. Selon les applications, les circuits extérieurs peuvent également comporter des moyens d'inversion du sens de circulation du fluide thermique.

La plaque d'interface 3a est agencée pour se plaquer contre les éléments thermiques 2a et pour assurer un raccordement par simple contact sans raccord mécanique interposé. A cet effet, elle comporte, en regard des orifices d'entrée 21 et de sortie 22 de chaque élément thermique 2a1, 2a2, des orifices de liaison 30 reliés deux à deux par des rainures ménagées sur la face de la plaque d'interface 3a opposée aux éléments thermiques 2a1, 2a2. La plaque d'interface 3a est superposée à une plaque d'obturation 5a du côté des rainures pour former la canalisation 34. La plaque d'interface 3a, la plaque d'obturation 5a et les éléments thermiques 2a1, 2a2 sont assemblés par des moyens d'étanchéité (non représenté) tels que par exemple une feuille de "Téflon", un joint liquide, un revêtement spécifique. Ces moyens d'étanchéité comportent, lorsqu'ils sont prévus entre la plaque d'interface 3a et les éléments thermiques 2a1, 2a2, des orifices de passage du fluide thermique en regard des orifices de liaison 30.

Les rainures sont disposées de manière à relier l'orifice d'entrée 21 du premier élément thermique 2a1, 2a2 de chaque ensemble à un orifice d'arrivée 31 et l'orifice de sortie 22 du dernier élément thermique 2a1, 2a2 de chaque ensemble à un orifice d'évacuation 32. A l'exclusion des orifices d'entrée 21 et de sortie 22 déjà raccordés, les rainures relient, pour chacun des ensembles, l'orifice de sortie 22 d'un élément thermique 2a1, 2a2 à l'orifice d'entrée 21 de l'élément thermique 2a1, 2a2 suivant. Les éléments thermiques 2a1 et 2a2 d'un même ensemble sont ainsi respectivement reliés en série. Afin d'éviter tout croisement des circuits d'interface 4a, les rainures suivent une trajectoire en demi-créneaux enchevêtrés. Ces rainures peuvent être réalisées par exemple par usinage, gravure ou moulage.

La plaque d'interface 3a telle que représentée peut être facilement adaptée à un nombre d'éléments thermiques 2a plus élevé notamment pour augmenter la capacité thermique de l'échangeur thermique 1a.

Le fonctionnement de l'échangeur thermique 1a peut être décomposé en deux étapes entre lesquelles les moyens de commutation sont basculés et le champ magnétique modifié. Ainsi, à chaque changement d'étape, le premier ensemble d'éléments thermiques 2a1 précédemment soumis au champ magnétique est soumis à l'absence de champ magnétique et inversement pour le second ensemble d'éléments thermiques 2a2. De plus, le premier circuit d'interface 4a1 précédemment relié au circuit extérieur "chaud" est relié au circuit extérieur "froid" et inversement pour le second circuit d'interface 4a2.

Dans une première étape de fonctionnement, les éléments thermiques 2a1 du premier ensemble soumis au champ magnétique s'échauffent et réchauffent le fluide thermique présent dans le premier circuit d'interface 4a1. En parallèle, les éléments thermiques 2a2 du second ensemble qui ne sont plus soumis au champ magnétique se refroidissent pour atteindre une température inférieure à leur température de départ et refroidissent le fluide thermique présent dans le second circuit d'interface 4a2.

Dans cette configuration en série, chaque fluide thermique entre dans la plaque d'interface 3a par un des orifices d'arrivée 31. Le fluide thermique du premier circuit d'interface 4a1 est réchauffé à une température +t1 par le premier élément thermique 2a1 du premier ensemble soumis au champ magnétique. Il est ensuite guidé par la canalisation 34 vers le second élément thermique 2a1 qui le réchauffe à une température +t2 supérieure à +t1 et ainsi de suite jusqu'au dernier élément thermique 2a1. Ensuite, le fluide thermique réchauffé sort de la plaque d'interface 3a par un des orifices d'évacuation 32 et guidé vers le circuit extérieur "chaud" où les calories sont évacuées, récupérées et utilisées par exemple au moyen d'un ou de plusieurs échangeurs de calories.

Simultanément, le fluide thermique du second circuit d'interface 4a2 est refroidi à une température -t1 par le premier élément thermique 2a2 du second ensemble non soumis au champ magnétique. Il est ensuite guidé par la canalisation 34 vers le second élément thermique 2a2 qui le refroidit à une température -t2 inférieure -t1 et ainsi de suite jusqu'au dernier élément thermique 2a2. Ensuite, le fluide thermique refroidi sort de la plaque d'interface 3a par l'autre orifice d'évacuation 32 et est guidé vers le circuit extérieur "froid" où les frigories sont évacuées, récupérées et utilisées par exemple au moyen d'un ou de plusieurs échangeurs de frigories.

La seconde étape est sensiblement similaire à la première étape, les éléments thermiques 2a1 "chauffants" devenant "refroidissants" et les éléments thermiques 2a2 "refroidissants" devenant "chauffants". Le fonctionnement peut être poursuivi par une alternance des première et seconde étapes.

L'échangeur thermique 1a de ce premier mode de réalisation peut être raccordé à un autre échangeur thermique 1a similaire ou non, en série, en parallèle ou mixte série/parallèle. Ce raccordement peut être réalisé de manière traditionnelle par des tuyaux ou au moyen d'une plaque d'interface de liaison (non représentée) mettant en communication les plaques d'interface 3a de chaque échangeur thermique 1a ou encore au moyen d'une plaque d'interface multiple remplaçant les deux plaques d'interface 3a et la plaque de liaison.

### Meilleure manière de réaliser l'invention :

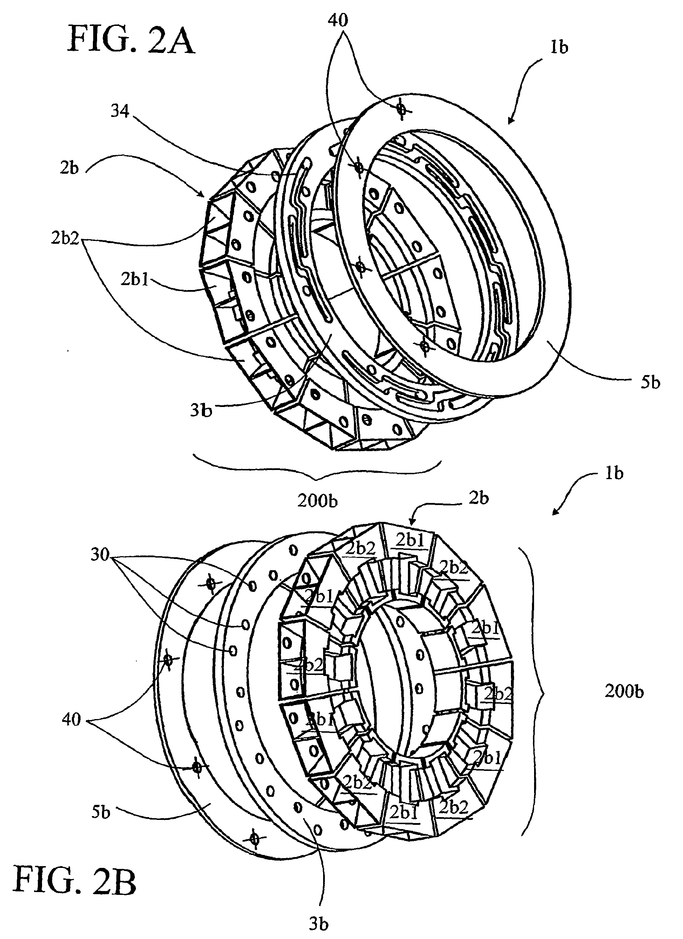

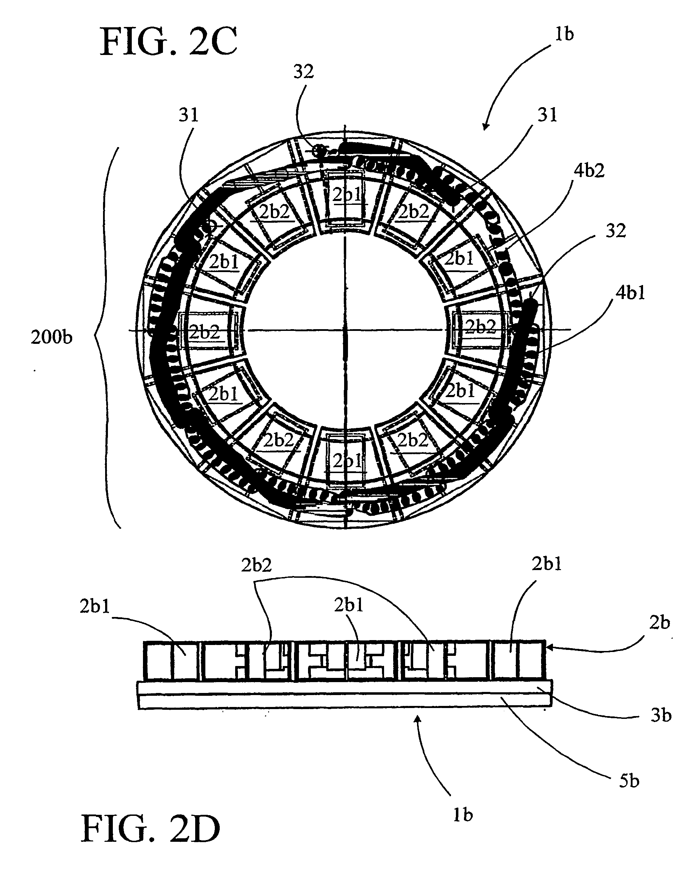

En référence aux figures 2A-D et selon un mode de réalisation préféré de l'invention, l'échangeur thermique 1b, sensiblement similaire au précédent, s'en différencie par sa configuration circulaire, qui permet d'animer les moyens magnétiques selon un mouvement circulaire et continu à la place d'un mouvement rectiligne et alternatif dans le cas d'une configuration linéaire. Il comporte un groupe 200b de douze éléments thermiques 2b1, 2b2 se présentant sous la forme de secteurs circulaires portés par une plaque d'interface 3b formant un anneau et pourvue de quatre orifices dont deux orifices d'arrivée 31 et deux orifices d'évacuation 32. Les orifices de liaison 30 et la canalisation 34 prévus dans la plaque d'interface 3b sont sensiblement similaires aux précédents. La plaque d'interface 3b est couplée à une plaque d'obturation 5b comportant des orifices traversants 40 prévus en regard des orifices d'arrivée 31 et d'évacuation 32 de la plaque d'interface 3b. Les éléments thermiques 2b1, 2b2 et la plaque d'interface 3b définissent deux circuits d'interface 4b1, 4b2. Le fonctionnement de cet échangeur thermique 1b est sensiblement similaire au précédent. L'échangeur thermique 1b de ce second mode de réalisation peut également être raccordé à un autre échangeur thermique 1b similaire ou non, en série, en parallèle ou mixte série/parallèle.

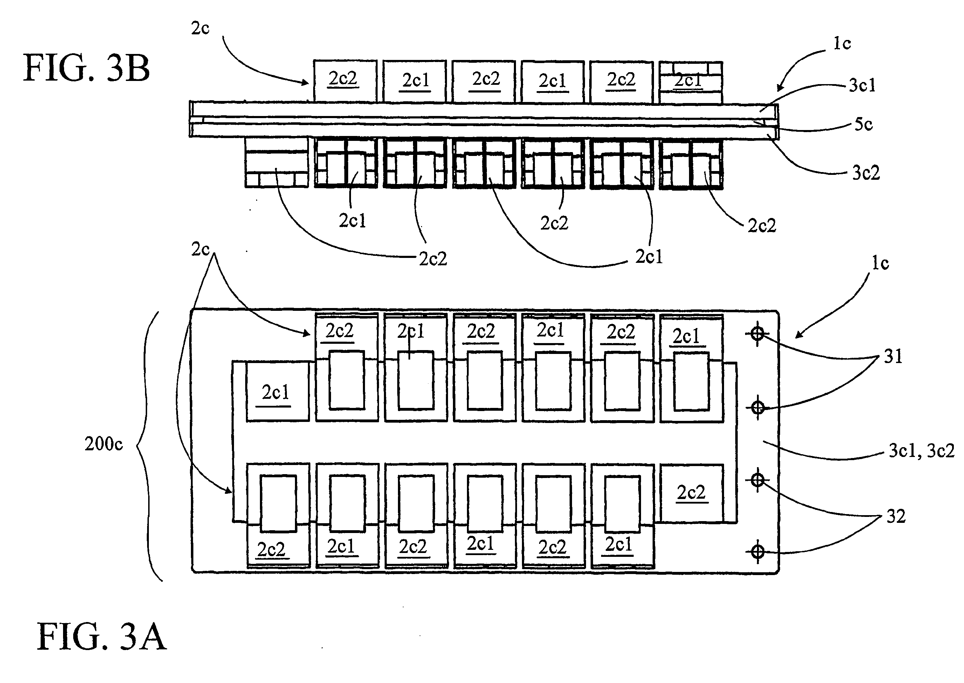

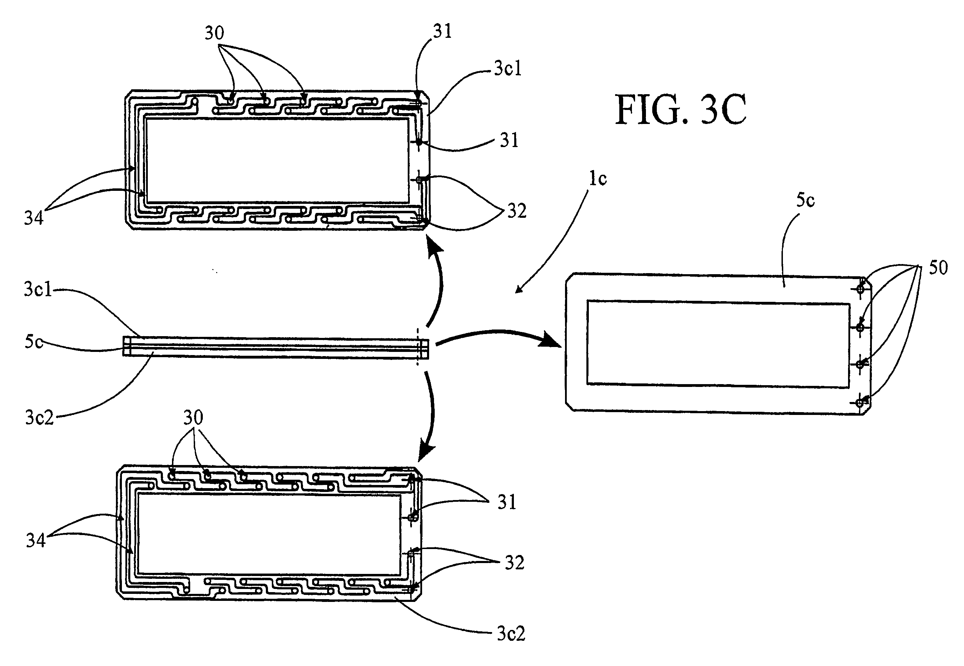

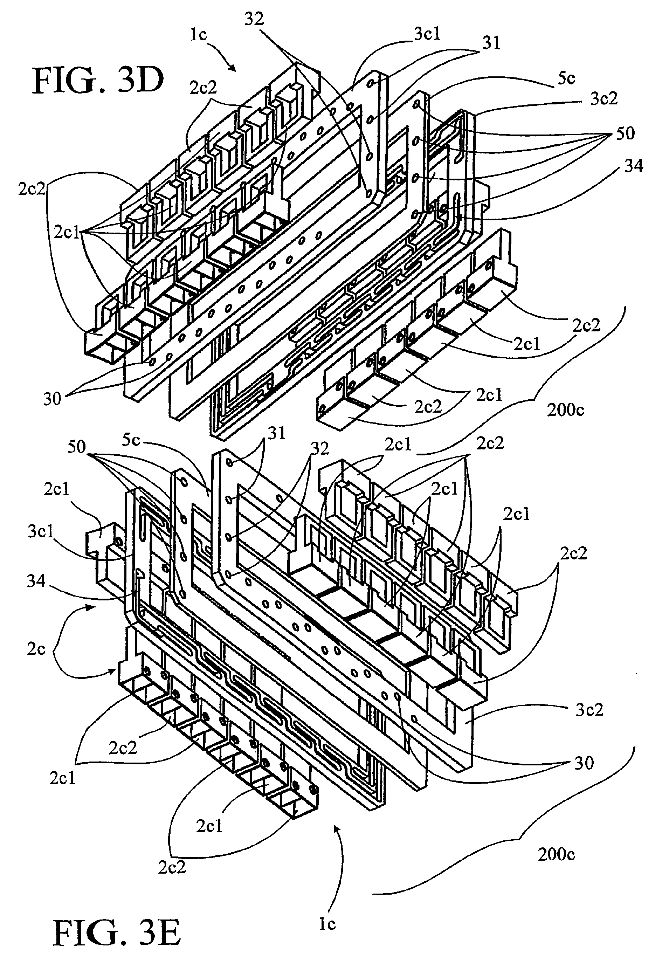

Selon un troisième mode de réalisation illustré par les figures 3A-E, l'échangeur thermique 1c comporte un groupe 200c constitué de deux échangeurs thermiques sensiblement similaires à celui des figures 1A-J superposés et combinés. Cet échangeur thermique 1c comporte donc quatre rangées de six éléments thermiques 2c1, 2c2 dont deux rangées sont portées par une première plaque d'interface 3c1 et les deux autres rangées sont portées par une seconde plaque d'interface 3c2 superposée à la première 3c1. Chaque plaque d'interface 3c1, 3c2 est similaire à la plaque d'interface 3a. Elle comporte quatre orifices dont deux orifices d'arrivée 31 et deux orifices d'évacuation 32, des orifices de liaison 30 et des canalisations 34 organisées de manière identique. Les plaques d'interface 3c1, 3c2 sont séparées par une plaque de d'obturation 5c comportant des orifices traversants 50 prévus en regard des orifices d'arrivée 31 et d'évacuation 32 des deux plaques d'interface 3c1, 3c2 pour raccorder leurs circuits d'interface (non représentés) en parallèle. Les plaques d'interface 3c1, 3c2 et la plaque d'obturation 5c sont assemblées par des moyens de fixation permanents ou non tels que par exemple le collage, la soudure, le vissage, le sertissage, le surmoulage. Le fonctionnement de cet échangeur de chaleur 1c est sensiblement similaire à celui des figures 1A-J. Les plaques d'interface 3c1, 3c2 peuvent être réalisées différemment, l'une reliant par exemple les éléments thermiques 2c1, 2c2 qu'elle porte en série et l'autre reliant les éléments thermiques 2c1, 2c2 qu'elle porte en parallèle comme décrit plus loin. Dans l'exemple décrit, les orifices d'arrivée 31 et d'évacuation 32 des deux plaques d'interface 3c1, 3c2 sont superposés et reliés en parallèle par les orifices traversants 50 de la plaque d'obturation 5 puis raccordés aux circuits extérieurs.

Selon une première variante de réalisation non représentée, il est possible de raccorder les plaques d'interface 3c1, 3c2 en série en prévoyant par exemple que la plaque de d'obturation 5c comporte :
- un orifice d'arrivée relié à l'orifice d'arrivée d'une première plaque d'interface 3c1,
- une canalisation reliant l'orifice d'évacuation de cette première plaque d'interface 3c1 à l'orifice d'arrivée de la seconde plaque d'interface 3c2,
- un orifice d'évacuation relié à l'orifice d'évacuation de la seconde plaque d'interface 3c2, la canalisation pouvant être formée par une rainure ou par un trou.

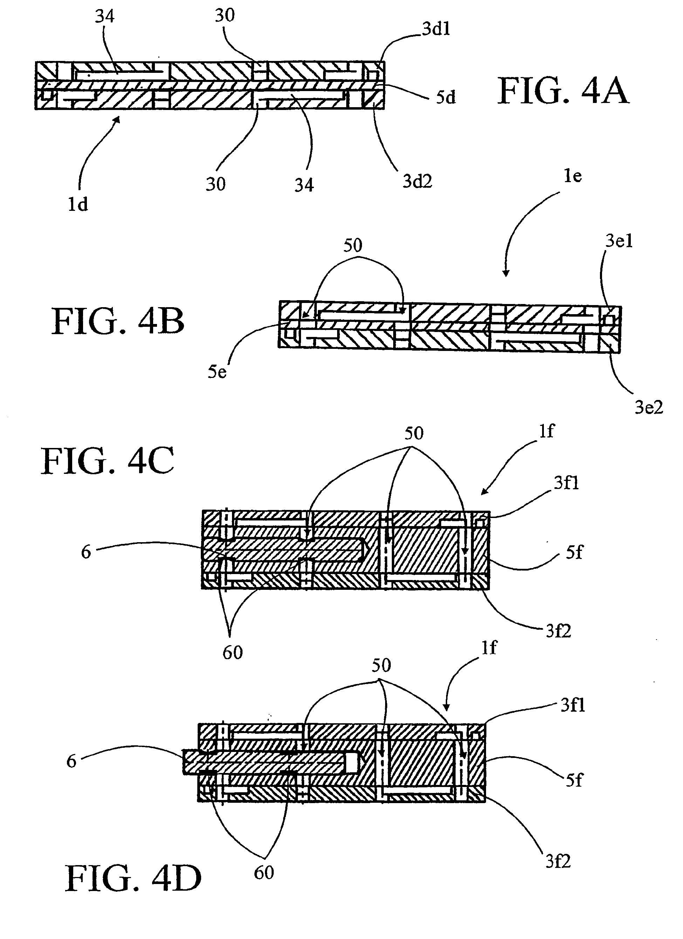

Selon une seconde variante de réalisation représentée par la figure 4A, l'échangeur thermique 1d, dont seuls les moyens de raccordement sont représentés, comporte des plaques d'interface 3d1, 3d2 séparées par une plaque d'obturation 5d interdisant tout passage de fluide thermique entre elles.

Selon une troisième variante de réalisation représentée par la figure 4B, l'échangeur thermique le , dont seuls les moyens de raccordement sont représentés, comporte des plaques d'interface 3e1, 3e2 séparées par une plaque d'obturation 5e pourvue d'orifices traversants 50 autorisant le passage de fluide thermique entre elles pour définir un circuit d'interface commun.

Selon une quatrième variante de réalisation non représentée, l'échangeur thermique peut comporter des plaques d'interface superposées sans plaque d'obturation. Dans ce cas, les canalisations de ces plaques d'interface peuvent comporter un ou plusieurs orifices traversants 20 permettant au fluide thermique de passer de l'une à l'autre et de définir un circuit d'interface commun.

Selon une cinquième variante de réalisation non représentée, l'échangeur thermique comporte des plaques d'interface dont les canalisations ne comportent pas d'orifice traversant, les circuits d'interface étant indépendants.

Les figures 4C et 4D illustrent une sixième variante de réalisation dans laquelle, la plaque d'obturation 5f comporte un commutateur 6 mobile entre une position ouverte (Cf. fig. 4C) et une position fermée (Cf. fig. 4D). Dans la position ouverte, le commutateur 6 autorise le passage du fluide thermique dans une partie de la plaque d'obturation 5f, d'une plaque d'interface 3f1 à l'autre plaque d'interface 3f2, et définit une partie du circuit d'interface. Dans la position fermée (Cf. fig. 4D), le commutateur 6 interdit le passage du fluide thermique au travers d'une partie de la plaque d'obturation 5f. Dans cet exemple, le commutateur 6 est un noyau circulaire pourvu de rainures circulaires 60. En position ouverte, les rainures circulaires 60 sont alignées avec les orifices traversants 50 de la plaque d'obturation 5f et les mettent en communication. En position fermée, les rainures circulaires 60 sont décalées et interdisent leur communication.

Selon d'autres modes de réalisation non représentés, le commutateur 6 peut être un coulisseau ou un tiroir dont le déplacement en translation et/ou en rotation peut être commandé par des moyens d'asservissement couplés par exemple aux moyens d'entraînement des aimants permanents. Il est également possible de prévoir un commutateur 6 mobile entre un nombre supérieur de positions. Le commutateur 6, selon sa position, sa conception et celle des orifices traversants, permet d'effectuer de raccorder les circuits d'interface des plaques d'interface 3f1, 3f2 en série, en parallèle ou mixte série/parallèle.

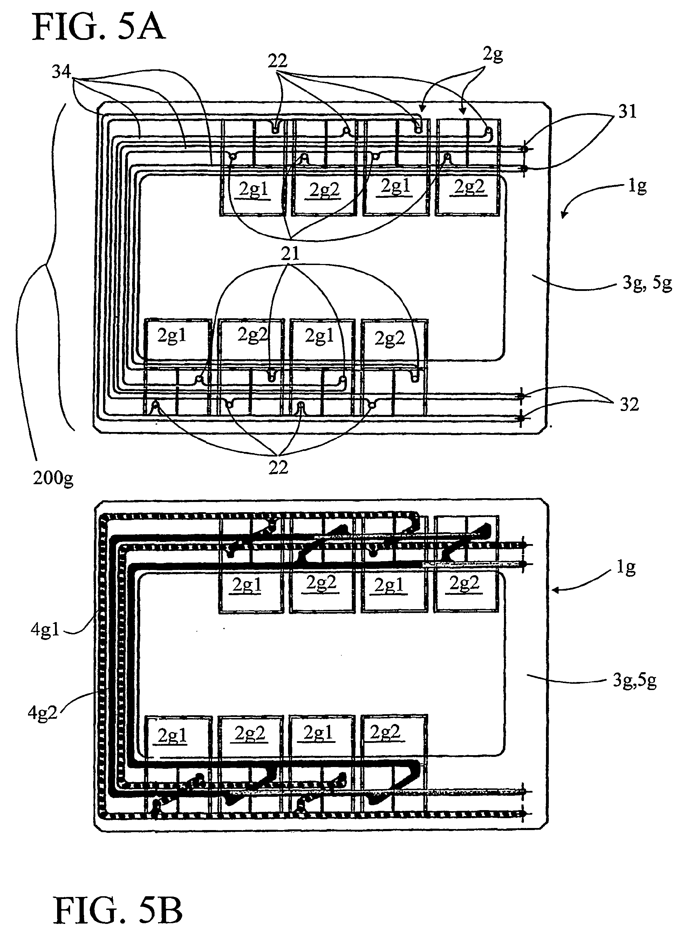

Selon un quatrième mode de réalisation illustré par les figures 5A et 5B, l'échangeur thermique 1g comporte un groupe 200g de deux rangées de quatre éléments d'interface 2g1, 2g2 portés par une plaque d'interface 3g formant un cadre rectiligne. Cette plaque d'interface 3g comporte deux canalisations 34 agencées de manière à relier en parallèle :
- tous les orifices d'entrée 21 des éléments thermiques 2g1 d'un premier ensemble avec un premier orifice d'arrivée 31,
- tous les orifices de sortie 22 des éléments thermiques 2g1 du premier ensemble avec un premier orifice d'évacuation 32, et, de manière similaire,
- tous les orifices d'entrée 21 et de sortie 22 des éléments thermiques 2g2 du second ensemble 2 respectivement avec les seconds orifices d'arrivée 31 et d'évacuation 32.

Cette configuration permet ainsi de définir deux circuits d'interface 4g1 et 4g2 dans chacun desquels les éléments d'interfaces 2g1 et 2g2 sont respectivement raccordés en parallèle. Comme dans les exemples précédents, les orifices d'arrivée 31 et d'évacuation 32 de la plaque d'interface 3g sont raccordés à des circuits extérieurs.

Le fonctionnement de cet échangeur thermique 1g peut être décomposé en deux étapes :
- une première étape dans laquelle les éléments thermiques 2g1 du premier ensemble qui sont soumis au champ magnétique s'échauffent et réchauffent simultanément le fluide thermique présent dans le premier circuit d'interface 4g1 et, dans laquelle, de manière simultanée, les éléments thermiques 2g2 du second ensemble qui ne sont plus soumis au champ magnétique se refroidissent et refroidissent simultanément le fluide thermique présent dans le second circuit d'interface 4g2, et
- une seconde étape dans laquelle la situation est inversée, les éléments thermiques 2g1 du premier ensemble qui ne sont plus soumis au champ magnétique se refroidissent et les éléments thermiques 2g2 du second ensemble qui sont soumis au champ magnétique s'échauffent.

Le passage d'une étape à l'autre est obtenu par des moyens de commutation et le déplacement du champ magnétique.

Dans cette configuration parallèle, les fluides thermiques entrent simultanément dans la plaque d'interface 3g par les deux orifices d'arrivée 31. Le fluide thermique du premier circuit d'interface 4g1 est simultanément réchauffé à une température +t par l'ensemble des éléments thermiques 2g1 du premier ensemble soumis au champ magnétique. Il est ensuite guidé vers l'extérieur de la plaque d'interface 3g par un premier orifice d'évacuation 32 vers le circuit extérieur "chaud" où les calories sont évacuées, récupérées et utilisées par exemple au moyen d'un ou de plusieurs échangeurs de calories. En même temps, le fluide thermique du second circuit 4g2 est simultanément refroidi à une température -t par l'ensemble des éléments thermiques 2g2 du second ensemble non soumis au champ magnétique. Il est ensuite guidé vers l'extérieur de la plaque d'interface 3g par le second orifice d'évacuation 32 vers le circuit extérieur "froid" où les frigories sont évacuées par exemple au moyen d'un ou de plusieurs échangeur de frigories.

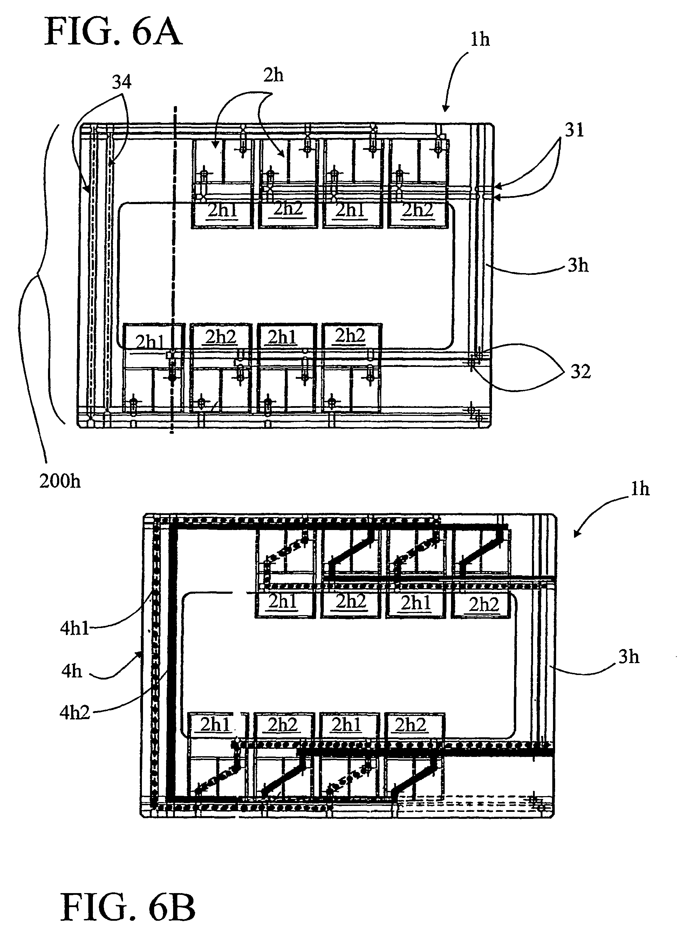

En référence aux figures 6A et 6B et selon un cinquième mode de réalisation, l'échangeur thermique 1h, sensiblement similaire au précédent, s'en différencie par ses canalisations 34 qui sont formées par un réseau de trous traversants prévus dans l'épaisseur de la plaque d'interface 3h. Ces trous traversants, réalisés par exemple par moulage, par usinage ou toute autre technique adaptée, sont pourvus de bouchons (non représentés) permettant de les obturer sélectivement pour former les circuits d'interface 4h1, 4h2. Selon la configuration choisie, ces trous traversants peuvent être prévus à un même niveau dans la plaque d'interface 3h ou à des niveaux différents permettant d'éviter les intersections. Cette solution présente l'avantage de ne pas nécessiter de plaque d'obturation. Le fonctionnement de cet échangeur thermique 1h est sensiblement similaire au précédent, les éléments thermiques 2h1, 2h2 de chaque ensemble étant raccordés en parallèle pour définir deux circuits d'interface 4h1, 4h2.

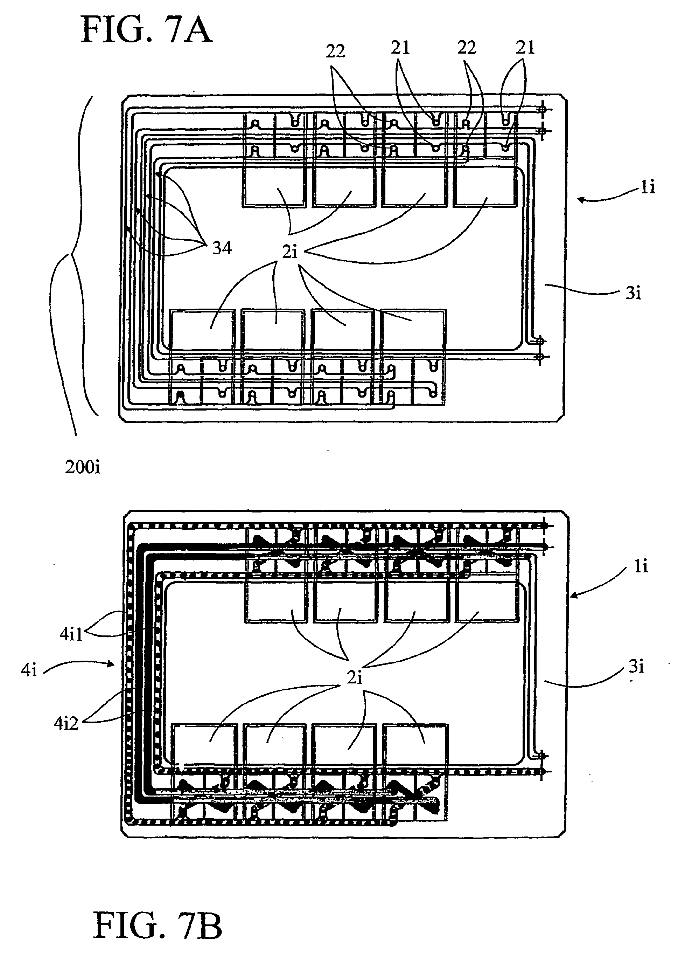

En référence aux figures 7A et 7B et selon un sixième mode de réalisation, l'échangeur thermique 1i, sensiblement similaire à celui des figures 5A et 5B, s'en différencie par le fait que chacun de ses éléments thermiques 2i est traversé par deux conduits et comporte donc quatre orifices dont deux orifices d'entrée 21 et deux orifices de sortie 22. Les canalisations 34 de la plaque d'interface 3i raccordent simultanément tous les éléments thermiques 2i à un premier circuit d'interface 4i1 et ces mêmes éléments thermiques 2i à un second circuit d'interface 4i2, ces circuits d'interface 4i1 et 4i2 étant indépendants. Le fonctionnement de cet échangeur thermique 1i peut être décomposé en deux étapes représentées de manière schématique et superposées par la figure 7B :
- une première étape dans laquelle tous les éléments thermiques 2i sont soumis au champ magnétique, s'échauffent et réchauffent le fluide thermique présent dans le premier circuit d'interface 4i1, et
- une seconde étape dans laquelle tous les éléments thermiques 2i ne sont plus soumis au champ magnétique, se refroidissent et refroidissent le fluide thermique présent dans le second circuit d'interface 4i2.

Le passage d'une étape à l'autre est obtenu par exemple par l'alimentation alternative d'électro-aimants fixes prévus en regard des éléments thermiques 2i. Cet échangeur thermique 1i peut bien entendu être combiné à un autre échangeur thermique 1i similaire ou non par le biais d'une plaque d'interface de liaison ou de tout autre moyen adapté.

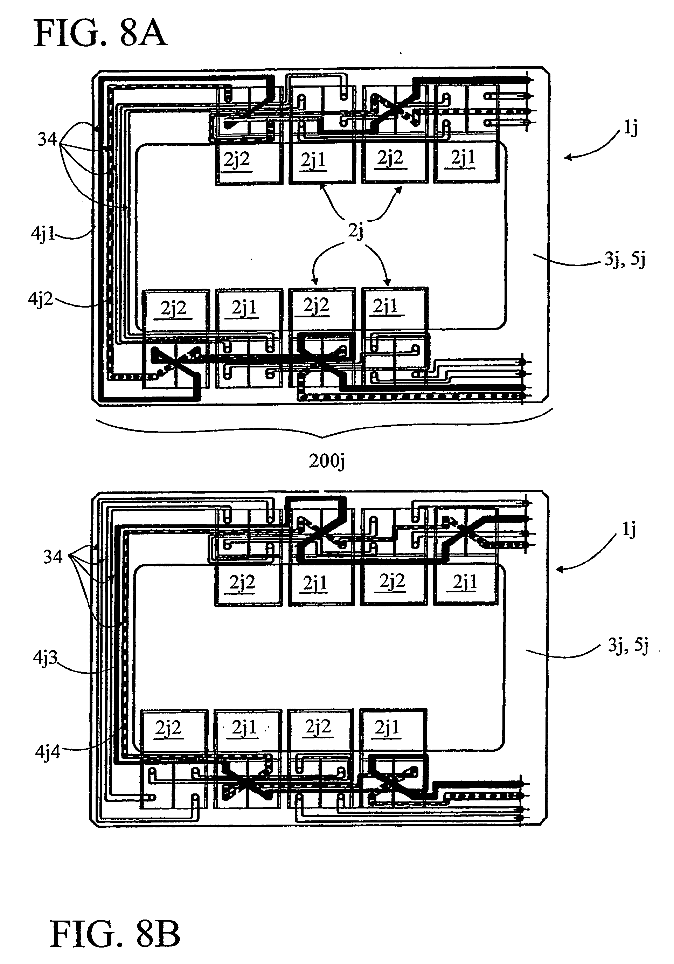

Les figures 8A illustrent un échangeur thermique 1j sensiblement similaire au précédent. Les éléments thermiques 2j1 et 2j2 portés par la plaque d'interface 3j sont traversés par deux conduits raccordés en série. Le fonctionnement de cet échangeur thermique 1j peut être décomposé en deux étapes, représentées séparément par les figures 8A et 8B, sensiblement similaires aux deux étapes de l'échangeur de chaleur 1a des figures 1A-J. Cette configuration est particulière car les conduits 20 des éléments thermiques 2j1, 2j2 et les canalisations 34 définissent quatre circuits d'interface 4j1, 4j2, 4j3 et 4j4. En effet, cet échangeur thermique 1j permet de s'affranchir des moyens de commutation nécessaires pour raccorder alternativement les éléments thermiques 1j aux circuits extérieurs "chaud" et "froid". Cet échangeur thermique 1j peut bien entendu être combiné à un autre échangeur thermique 1j similaire ou non par le biais d'une plaque d'interface de liaison ou de tout autre moyen adapté.

En référence aux figures 9-11, les échangeurs thermiques 1k-o comportent plusieurs groupes 200k-o d'éléments thermiques 2k-o et des moyens de raccordement complémentaires 300 k-o les mettant en communication. Dans ces exemples, les moyens de raccordement complémentaires sont couplés aux plaques d'interface 3k-o et comportent une ou plusieurs canalisations complémentaires 340 reliant les canalisations 34 (non représentées sur ces figures) de chacun des groupes 200k-o.

Dans l'exemple illustré par les figures 9A et 9B, l'échangeur thermique 1k comporte deux groupes 200k, 200k' d'éléments thermiques 2k, 2k' pourvus chacun d'une plaque d'interface 3k, 3k' sensiblement similaire à celle des figures 2A-C. Les plaques d'interface 3k, 3k' comportent des prolongements latéraux 300k, 300k' s'étendant axialement, comportant une canalisation complémentaire 340 et définissant les moyens de raccordement complémentaires. La canalisation complémentaire 340de chaque prolongement latéral 300k, 300k' comporte deux conduits 341, 342 et deux orifices de raccordement 343 vers un circuit extérieur ou vers une autre plaque d'interface. Les groupes 200k, 200k' sont superposés de sorte que les conduits 341, 342 sont disposés en prolongement les uns des autres. Les conduits 341, 342 sont ainsi prévus pour définir un circuit de raccordement complémentaire reliant les circuits d'interface de chaque groupe 200k, 200k' en série, en parallèle ou selon une combinaison mixte série/parallèle.

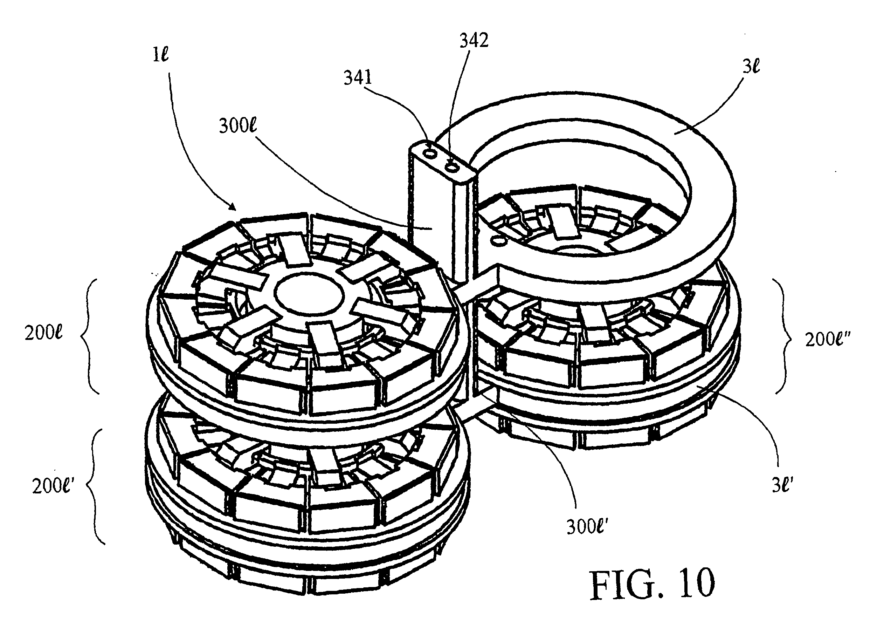

L'échangeur thermique 11 représenté par la figure 10 est construit de manière sensiblement similaire au précédent. Il comporte quatre groupes 200ℓ, 200ℓ', 200ℓ" d'éléments thermiques 21, 21", 21" (dont seulement trois sont représentés), portés par deux paires de plaques d'interface 31, 31' permettant de disposer les groupes 2001, 2001', 2001", cote à cote deux à deux et empilés. Chaque paire de plaques d'interface 31, 31' comporte un prolongement latéral 3001, 3001' pourvu de conduits 341, 342 et d'orifices de raccordement (non représentés) prévus pour définir un circuit de raccordement complémentaire reliant les circuits d'interface des groupes 2001, 2001', 2001" en série, en parallèle ou selon une combinaison mixte série/parallèle. Il est bien entendu possible de prévoir des plaques d'interface triples ou autres permettant de multiplier les groupes d'éléments thermiques.

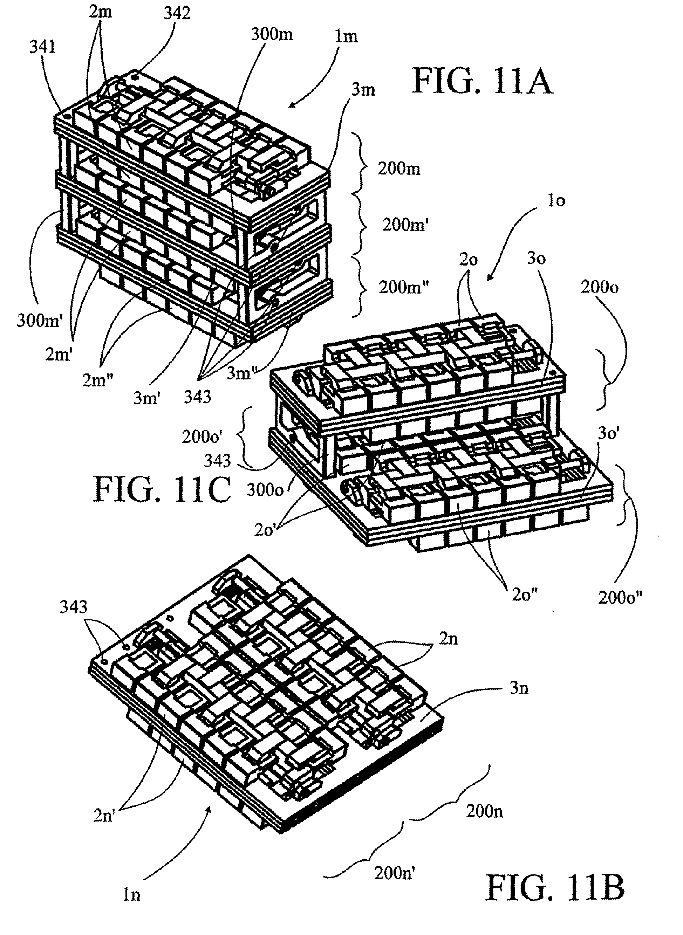

Les échangeurs thermiques 1m-o représentés par les figures 11A-C sont construits de manière sensiblement similaire à ceux des figures 3A-E.

L'échangeur thermique 1m de la figure 11A comporte trois groupes 200m, 200m', 200m" d'éléments thermiques 2m, 2m', 2m" superposés par des plaques d'interface 3m, 3m', 3m". Deux des plaques d'interface 3m, 3m', 3m" comportent deux prolongements latéraux 300m, 300m' pourvus de conduits 341, 342 et d'orifices de raccordement 343 pour définir un circuit de raccordement complémentaire reliant les circuits d'interface des différents groupes en série, en parallèle ou selon une combinaison série/parallèle.

L'échangeur thermique 1n de la figure 11B comporte deux groupes 200n, 200n' d'éléments thermiques 2n, 2n' portés par une plaque d'interface 3n unique permettant d'aligner les groupes 200n, 200n' cote à cote. Cette plaque d'interface 3n comporte une canalisation complémentaire (non représentée) permettant de raccorder les circuits d'interface des groupes 200n, 200n' en série, en parallèle ou selon une combinaison série/parallèle. Elle comporte de plus des orifices de raccordement 343 autorisant son raccordement à un circuit extérieur ou à une autre plaque d'interface.

L'échangeur thermique 1o de la figure 11C combine les deux exemples précédents en permettant la superposition combinée à la disposition cote à cote de trois groupes 200o, 200o', 200o" d'éléments thermiques 2o, 2o', 2o" et leur liaison par un circuit complémentaire au moyen de deux plaques d'interface 3o, 3o'.

Ces derniers modes de réalisation permettent de moduler à volonté la configuration et le fonctionnement des échangeurs thermiques selon l'invention pour obtenir une puissance thermique plus importante ou une intensité thermique plus élevée.

Dans ces exemples, les champs magnétiques sont générés par des aimants permanents, des assemblages magnétiques mobiles ou des électro-aimants fixes alternativement alimentés. Ils peuvent bien entendu être générés par tout autre moyen équivalent.

### Possibilités d'application industrielle :

Cette description met bien en évidence que l'échangeur thermique 1a-o selon l'invention permet de répondre aux buts fixés. Il permet notamment de raccorder de manière fiable et simple, un nombre important d'éléments thermiques 2a-o en remplaçant les tuyaux et les raccords traditionnels par une plaque d'interface 3a-o intégrant les canalisations 34 sous forme de rainures et/ou de trous et les raccords sous forme d'orifices de liaison 30 et d'orifices traversants 40, 50. Cette interface autorise à la fois le raccordement d'éléments thermique 2a-o d'un même groupe 200a-o et/ou de plusieurs groupes 200a-o distincts et/ou de plusieurs échangeurs thermiques 1a-o en série, en parallèle ou mixte et permet ainsi d'obtenir des configurations actuellement difficiles voire impossibles à réaliser. Elle permet une réduction considérable du nombre de pièces mécaniques augmentant la fiabilité d'utilisation, limitant les fuites et réduisant le coût de fabrication et de maintenance de l'échangeur thermique 1a-o.

Ce type d'échangeur thermique 1a-o peut être utilisé pour toute application industrielle ou domestique de refroidissement, de chauffage, de climatisation, de tempérage.

La présente invention n'est pas limitée aux exemples de réalisation décrits mais s'étend à toute modification et variante évidentes pour un homme du métier tout en restant dans l'étendue de la protection définie dans les revendications annexées.

## Revendications

1. Echangeur thermique (1a-o) comportant au moins un groupe (200a-o) d'au moins deux éléments thermiques (2a-o) émetteurs de calories et/ou de frigories et pourvus chacun d'au moins un orifice d'entrée (21) et d'au moins un orifice de sortie (22) reliés par au moins un conduit (20) traversant ledit élément thermique (2a-o) apte à recevoir un fluide thermique agencé pour récupérer lesdites calories et/ou lesdites frigories, ledit échangeur thermique (1a-o) comportant des moyens de raccordement (3a-o) agencés pour raccorder lesdits conduits (20) entre eux et à au moins un circuit extérieur audit échangeur thermique (1a-o) agencé pour utiliser les calories et/ou les frigories récupérées par ledit fluide thermique, **caractérisé en ce que** lesdits moyens de raccordement comportent au moins une plaque d'interface (3a-o) plaquée contre lesdits éléments thermiques (2a-o), comprenant au moins une canalisation (34) pourvue d'orifices de liaison (30) disposés en regard des orifices d'entrée (21) et de sortie (22) desdits éléments thermiques (2a-o) et agencée pour définir au moins un circuit d'interface (4a-o) autorisant la circulation dudit fluide thermique entre lesdits éléments thermiques (2a-o) et ladite plaque d'interface (3a-o) selon un raccordement série, parallèle ou mixte, ladite plaque d'interface (3a-o) comportant également au moins un orifice d'arrivée (31) et au moins un orifice d'évacuation (32) agencés pour raccorder ledit circuit d'interface (4a-o) audit circuit extérieur.

2. Echangeur thermique (1a-o) selon la revendication 1, **caractérisé en ce que** lesdits éléments thermiques (2a-o) émettent alternativement des calories et des frigories et **en ce que** ladite plaque d'interface (3a-o) comporte au moins deux canalisations (34) pourvues chacune d'au moins un orifice d'arrivée (31), un orifice d'évacuation (32) et des orifices de liaison (30), et agencées pour définir deux circuits d'interface (4a-o) distincts raccordés à deux circuits extérieurs.

3. Echangeur thermique (1k-o) selon la revendication 1, **caractérisé en ce qu'**il comporte au moins deux groupes (200k-o) d'éléments thermiques (2k-o) pourvus chacun d'au moins une plaque d'interface (3k-o) et de moyens de raccordement complémentaires (300k-o) agencés pour raccorder lesdites plaques d'interface (3k-o) entre elles et les circuits d'interface desdits groupes (200 k-o) correspondants selon un raccordement série, parallèle ou mixte.

4. Echangeur thermique (1c-f) selon la revendication 1, **caractérisé en ce que** lesdits moyens de raccordement comportent au moins deux plaques d'interface (3c1,3c2-3f1,3f2) superposées dos à dos, comportant chacune au moins une canalisation (34), un orifice d'arrivée (31), un orifice d'évacuation (32) et des orifices de liaison (30) raccordés à un ensemble d'éléments thermiques (2c-2f).

5. Echangeur thermique (1e, 1f) selon la revendication 4, **caractérisé en ce que** lesdites plaques d'interface (3e1,3e2, 3f1,3f2) comportent des orifices traversants (50) disposés en regard l'un de l'autre pour définir un circuit d'interface commun.

6. Echangeur thermique (1h) selon la revendication 1, **caractérisé en ce que** ladite canalisation (34) est au moins en partie formée par un réseau de trous traversants prévus dans l'épaisseur de ladite plaque d'interface (3h) et obturés sélectivement par des bouchons en fonction du circuit d'interface (4h) à réaliser.

7. Echangeur thermique (1a-g, 1j-o) selon la revendication 1, **caractérisé en ce que** ladite canalisation (34) est au moins en partie formée par une ou plusieurs rainures ménagées sur au moins une face de ladite plaque d'interface (3a-g, 3j-o).

8. Echangeur thermique (1a-g, 1j-o) selon la revendication 7, **caractérisé en ce que** lesdites rainures sont réalisées par usinage, gravure ou moulage.

9. Echangeur thermique (1a-g, 1j-o) selon la revendication 7, **caractérisé en ce que** lesdits moyens de raccordement comportent au moins une plaque d'obturation (5a-g, 5j) superposée à ladite plaque d'interface (3a-g, 3j) du côté desdites rainures pour former ladite canalisation (34).

10. Echangeur thermique (1c-f) selon les revendications 5 et 9, **caractérisé en ce que** ladite plaque d'obturation (4c-f) est disposée entre deux plaques d'interface (3c1,3c2-3f1,3f2) pour former avec chacune d'elle ladite canalisation (34).

11. Echangeur thermique (1c, 1e, 1f) selon la revendication 10, **caractérisé en ce que** ladite plaque d'obturation (5c, 5e, 5f) comporte des orifices traversants (50) débouchant dans lesdites canalisations (34) et agencés pour les raccorder selon un raccordement série, parallèle ou mixte.

12. Echangeur thermique (1f) selon la revendication 11, **caractérisé en ce que** ladite plaque d'obturation (5f) comporte un commutateur (6) mobile entre au moins deux positions de manière à modifier le mode de raccordement desdits circuits d'interface.

13. Echangeur thermique (1f) selon la revendication 12, **caractérisé en ce que** ledit commutateur (6) est choisi dans le groupe comprenant au moins un coulisseau, un noyau, un tiroir et **en ce qu'**il est commandé par des moyens d'asservissement.

14. Echangeur thermique (1a-o) selon la revendication 1, **caractérisé en ce que** lesdits moyens de raccordement comportent des moyens d'étanchéité disposés au moins entre lesdits éléments thermiques (2a-o) et ladite plaque d'interface (3a-o).

15. Echangeur thermique (1a-o) selon la revendication 14, **caractérisé en ce que** lesdits moyens d'étanchéité sont choisis dans le groupe comprenant un revêtement ou une feuille en "Téflon", un joint liquide.

16. Echangeur thermique (1a-o) selon la revendication 1, **caractérisé en ce que** lesdits moyens de raccordement sont réalisés au moins en partie dans un matériau thermiquement isolant.

## Claims

1. A heat exchanger (1a-o) comprising at least one group (200a-o) of at least two calorie- or frigorie-emitting thermal elements (2a-o), each provided with at least one inlet orifice (21) and at least one outlet orifice (22) connected by at least one conduit (20) traversing said thermal element (2a-o) capable of receiving thermal fluid designed to recover said calories and/or said frigories, said heat exchanger (1a-o) comprising connection means (3a-o) designed to connect said conduits (20) to one another and to at least one circuit external to said heat exchanger (1a-o) designed to utilize the calories and/or frigories recovered by said thermal fluid, **characterized in that** said connection means comprises at least one interface plate (3a-o) placed flat against said thermal elements (2a-o), comprising at least one channel (34) equipped with connecting orifices (30) facing the inlet orifices (21) and outlet orifices (22) in said thermal elements (2a-o) and defining at least one interface circuit (4a-o) allowing said thermal fluid to circulate between said thermal elements (2a-o) and said interface plate (3a-o) through a series, parallel, or mixed connection, said interface plate (3a-o) also comprising at least one supply orifice (31) and at least one discharge orifice (32) which connect said interface circuit (4a-o) to said exterior circuit.

2. A heat exchanger (1a-o) according to claim 1 **characterized in that** said thermal elements (2a-o) alternately emit calories and frigories, and **in that** said interface plate (3a-o) comprises at least two channels (34) each equipped with at least one supply orifice (31), one discharge orifice (32,), and connecting orifices (30) defining two distinct interface circuits (4a-o) connected to two external circuits.

3. A heat exchanger (1k-o) according to claim 1 **characterized in that** it comprises at least two groups (200k-o) of thermal elements (2k-o) each provided with at least one interface plate (3k-o) and complementary connection means (300k-o) for connecting said interface plates (3k-o) to one another and the interface circuits of said corresponding groups (200k-o) in a series, parallel, or mixed connection.

4. A heat exchanger (1c-f) according to claim 1 **characterized in that** said connection means comprises at least two interface plates (3c1, 3c2-3f1, 3f2) superimposed back to back, each comprising at least one channel (34), one supply orifice (31,) one discharge orifice (32), and connecting orifices (30) connected to a unit of thermal elements (2c-2f).

5. A heat exchanger (1e, 1f) according to claim 4 **characterized in that** said interface plates (3e1, 3e2, 3f1, 3f2) comprise traversing orifices (50) facing each other to define a common interface circuit.

6. A heat exchanger (1 h) according to claim 1 **characterized in that** said channel (34) is at least partially formed of a network of perforations through the wall of said interface plate (3h) selectively blocked by plugs depending upon the function of the interface circuit (4h) to be formed.

7. A heat exchanger (1a-g, 1j-o) according to claim 1 **characterized in that** said channel (34) is at least partially formed by one or more grooves located on at least one surface of said interface plate (3a-g, 3j-o).

8. A heat exchanger (1a-g, 1j-o) according to claim 7 **characterized in that** said grooves are formed by machining, engraving, or casting.

9. A heat exchanger (1a-g, 1j-o) according to claim 7 **characterized in that** said connection means comprise at least one closing plate (5a-g, 5j) superimposed on said interface plate (3a-g, 3j) on the grooved side to form said channel (34).

10. A heat exchanger (1c-f) according to claims 5 and 9 **characterized in that** said closing plate (4c-f) is located between two interface plates (3c1, 3c2-3f1, 3f2) to form with each one said channel (34).

11. A heat exchanger (1c, 1e, 1f) according to claim 10 **characterized in that** said closing plate (5c, 5e, 5f) comprises traversing orifices (50) opening into said channels (34) in order to connect them in a series, parallel, or mixed connection.

12. A heat exchanger (1f) according to claim 11 **characterized in that** said closing plate (5f) comprises a switch (6) movable between at least two positions so as to modify the mode of connection between said interface circuits.

13. A heat exchanger (1f) according to claim 12 **characterized in that** said switch (6) is chosen from the group comprising at least a slide block, a core, or a sliding unit and it is controlled by a driving mechanism.

14. A heat exchanger (1a-o) according to claim 1 **characterized in that** said connection means comprises sealing elements located at least between said thermal elements (2a-o) and said interface plate (3a-o).

15. A heat exchanger (1a-o) according to claim 14 **characterized in that** said sealing means are selected from the group comprising a coating, a Teflon sheet, or a liquid seal.

16. A heat exchanger (1a-o) according to claim 1 **characterized in that** said connection means is at least partially made of a thermally insulating material.

## Patentansprüche

1. Wärmetauscher (1a-o), der mindestens eine Gruppe (200a-o) aus mindestens zwei Thermostrahlern (2a-o) für Wärme und/oder Kälte aufweist, die jeweils mit mindestens einer Eingangsöffnung (21) und mit mindestens einer Ausgangsöffnung (22) versehen sind, die mittels mindestens einer Leitung (20) verbunden sind, die das Thermoelement (2a-o) durchquert, welches in der Lage ist, ein Thermofluid aufzunehmen, welches vorgesehen ist, um die Wärme und/oder die Kälte wieder aufzunehmen, wobei der Wärmetauscher (1a-o) Verbindungseinrichtungen (3a-o) aufweist, die zum Verbinden der Leitungen (20) untereinander und mit mindestens einem Stromkreis außerhalb des Wärmetauscher (1a-o) angeordnet sind, der zur Verwendung der durch das Thermofluid wieder aufgenommenen Wärme und/oder Kälte vorgesehen ist, **dadurch gekennzeichnet, dass** die Verbindungseinrichtungen mindestens eine Schnittstellenplatte (3a-o) aufweisen, die gegen die Thermoelemente (2a-o) gedrückt ist und mindestens eine Rohrleitung (34) aufweist, die mit Verbindungsöffnungen (30) versehen ist, die den Eingangs-(21) und Ausgangsöffnungen (22) der Thermoelemente (2a-o) gegenüberliegend angeordnet und dafür vorgesehen sind, mindestens einen Schnittstellenstromkreis (4a-o) festzulegen, der die Zirkulation des Thermofluids zwischen den Thermoelementen (2a-o) und der Schnittstellenplatte (3a-o) gemäß einer Reihen-, Parallel- oder Mischverbindung zulässt, wobei die Schnittstellenplatte (3a-o) außerdem mindestens eine Eingangsöffnung (31) und mindestens eine Ausstoßöffnung (32) aufweist, die zum Verbinden des Schnittstellenstromkreises (4a-o) mit dem externen Stromkreis vorgesehen sind.

2. Wärmetauscher (1a-o) nach Anspruch 1, **dadurch gekennzeichnet, dass** die Thermoelemente (2a-o) alternativ Wärme und Kälte ausstrahlen, und dass die Schnittstellenplatte (3a-o) mindestens zwei Rohrleitungen (34) aufweist, die jeweils mit mindestens einer Eingangsöffnung (31), einer Ausstoßöffnung (32) und Verbindungsöffnungen (30) versehen und dafür vorgesehen sind, zwei getrennte Schnittstellenstromkreise (4a-o) festzulegen, die mit zwei Außenstromkreisen verbunden sind.

3. Wärmetauscher (1k-o) nach Anspruch 1, **dadurch gekennzeichnet, dass** er mindestens zwei Gruppen (200k-o) von Thermoelementen (2k-o) aufweist, die jeweils mit mindestens einer Schnittstellenplatte (3k-o) und mit ergänzenden Verbindungseinrichtungen (300k-o) versehen ist, um die Schnittstellenplatten (3k-o) untereinander und die Schnittstellenstromkreise der entsprechenden Gruppen (200k-o) gemäß einer Reihen-, Parallel- oder Mischverbindung untereinander zu verbinden.

4. Wärmetauscher (1c-f) nach Anspruch 1, **dadurch gekennzeichnet, dass** die Verbindungseinrichtungen mindestens zwei Schnittstellenplatten (3c1,3c2-3f1,3f2) aufweisen, die Rücken an Rücken übereinandergelagert sind, die jeweils mindestens eine Rohrleitung (34), eine Eingangsöffnung (31), eine Ausstoßöffnung (32) und Verbindungsöffnungen (30) aufweisen, die mit einer Gesamtheit von Thermoelementen (2c-2f) verbunden sind.

5. Wärmetauscher (1e,1f) nach Anspruch 4, **dadurch gekennzeichnet, dass** die Schnittstellenplatten (3e1,3e2,3f1,3f2) Durchgangsöffnungen (50) aufweisen, die einander gegenüberliegend angeordnet sind, um einen gemeinsamen Schnittstellenstromkreis festzulegen.

6. Wärmetauscher (1h) nach Anspruch 1, **dadurch gekennzeichnet, dass** die Rohrleitung (34) mindestens teilweise aus einem Netz aus Durchgangslöchern ausgebildet ist, die in der Dicke der Plattenschnittstelle (3h) vorgesehen und selektiv mittels Pfropfen in Abhängigkeit von dem zu realisierenden Schnittstellenstromkreis (4h) zu verschließen sind.

7. Wärmetauscher (1a-g, 1j-o) nach Anspruch 1, **dadurch gekennzeichnet, dass** die Rohrleitung (34) mindestens teilweise aus einer oder mehreren Nuten ausgebildet ist, die auf mindestens einer Seite der Schnittstellenplatte (3a-g,3j-o) eingearbeitet sind.

8. Wärmetauscher (1a-g,1j-o) nach Anspruch 7, **dadurch gekennzeichnet, dass** die Nuten mittels Bearbeitung, Gravur oder Abformen realisiert sind.

9. Wärmetauscher (1a-g,1j-o) nach Anspruch 7, **dadurch gekennzeichnet, dass** die Verbindungseinrichtungen mindestens eine Verschlussplatte (5a-g,5j) aufweisen, die zwecks Ausbildung der Rohrleitung (34) auf der Seite der Nuten über der Schnittstellenplatte (3a-g,3j) gelagert ist.

10. Wärmetauscher (1c-f) nach den Ansprüchen 5 bis 9, **dadurch gekennzeichnet, dass** die Verschlussplatte (4c-f) zwischen zwei Schnittstellenplatten (3c1,3c2-3f1,3f2) angeordnet ist, um mit jeder derselben die Rohrleitung (34) auszubilden.

11. Wärmetauscher (1c,1e,1f) nach Anspruch 10, **dadurch gekennzeichnet, dass** die Verschlussplatte (5c,5e,5f) Durchgangsöffnungen (50) aufweist, die in die Rohrleitungen (34) einmünden und angeordnet sind, um sie gemäß einer Reihen-, Parallel- oder Mischverbindung untereinander zu verbinden.

12. Wärmetauscher (1f) nach Anspruch 11, **dadurch gekennzeichnet, dass** die Verschlussplatte (5f) einen Schalter (6) aufweist, der zwischen mindestens zwei Positionen so bewegbar ist, dass er die Verbindungsart der Schnittstellenstromkreise verändert.

13. Wärmetauscher (1f) nach Anspruch 12, **dadurch gekennzeichnet, dass** der Schalter (6) aus der Gruppe ausgewählt wird, die mindestens ein Gleitstück, einen Kern und ein Schubfach umfasst, und dass er durch Regelungseinrichtungen gesteuert wird.

14. Wärmetauscher (1a-o) nach Anspruch 1, **dadurch gekennzeichnet, dass** die Verbindungseinrichtungen Abdichtungseinrichtungen aufweisen, die mindestens zwischen den Thermoelementen (2a-o) und der Schnittstellenplatte (3a-o) angeordnet sind.

15. Wärmetauscher (1a-o) nach Anspruch 14, **dadurch gekennzeichnet, dass** die Abdichtungseinrichtungen aus der Gruppe ausgewählt sind, die einen Überzug oder eine Folie aus "Teflon" und eine Flüssigkeitsdichtung umfasst.

16. Wärmetauscher (1a-o) nach Anspruch 1, **dadurch gekennzeichnet, dass** die Verbindungseinrichtungen mindestens teilweise aus einem thermisch isolierenden Werkstoff ausgeführt sind.
